**Europäisches Patentamt**

**European Patent Office**

**Office européen des brevets**

(19)

(11) Veröffentlichungsnummer : **0 120 834**
**B1**

(12) **EUROPÄISCHE PATENTSCHRIFT**

(45) Veröffentlichungstag der Patentschrift :
25.05.88

(21) Anmeldenummer : 84890035.3

(22) Anmeldetag : 29.02.84

(51) Int. Cl.⁴ : **G 03 F   1/00**

(54) Optisch strukturiertes Filter und Verfahren zu dessen Herstellung.

(30) Priorität : 01.03.83 AT 717/83

(43) Veröffentlichungstag der Anmeldung :
03.10.84 Patentblatt 84/40

(45) Bekanntmachung des Hinweises auf die Patenterteilung : 25.05.88 Patentblatt 88/21

(84) Benannte Vertragsstaaten :
AT BE CH DE FR GB IT LI LU NL SE

(56) Entgegenhaltungen :
DE-A- 2 623 688
GB-A- 1 577 479
GB-A- 1 583 459
GB-A- 2 079 536
US-A- 4 144 066
CHEMICAL ABSTRACTS, Band 98, Nr. 18, 2. Mai 1983,
Seite 543, Nr. 152099a, Columbus, Ohio, USA A.L.
KAMARDIN et al.: "Change in optical properties of
thin films as a result of ion bombardment" &
POVERKHNOST 1982, (4), 87-89
PATENTS ABSTRACTS OF JAPAN, Band 6, Nr. 262(P-
164)(1140), 21. Dezember 1982 & JP - A - 57 157 248
(NIPPON DENKI K.K.) 28.09.1982
PATENTS ABSTRACTS OF JAPAN, Band 6, Nr. 129(P-
128)(1007), 15. Juli 1982 & JP - A - 57 54939 (MATSUS-
HITA DENKI SANGYO K.K.) 01.04.1982
PATENTS ABSTRACTS OF JAPAN, Band 6, Nr. 104(P-
122)(982), 15. Juni 1982 & JP - A - 57 35859 (TOKYO
SHIBAURA DENKI K.K.) 26.02.1982
PATENTS ABSTRACTS OF JAPAN, Band 7, Nr. 196(P-
219)(1341), 26. August 1983 & JP - A - 58 93052 (SUWA
SEIKOSHA K.K.) 02.06.1983

(73) Patentinhaber : Österreichisches Forschungszentrum
Seibersdorf Ges.m.b.H.
Kramergasse 1
A-1010 Wien (AT)

(72) Erfinder : Stangl, Günther
Auerhahngasse 9
A-1210 Wien (AT)
Erfinder : Rüdenauer, Friedrich, Prof. Dr.
Nordmanngasse 9
A-1210 Wien (AT)

## Beschreibung

Die Erfindung bezieht sich auf ein Verfahren zur Herstellung von optisch strukturierten Filtern mit weitgehend glatten Oberflächen, insbesondere von Arbeitsmasken für die photolithographische Herstellung von mikroelektronischen Bauteilen, mit zumindest einem Muster mit gegenüber der Filterschicht unterschiedlicher Transmission für die zu filternde elektromagnetische Strahlung, wobei in die Filterschicht zur Erzeugung der (des) Muster(s) entsprechend der zu erzeugenden Musterkonfiguration(en) Ionen implantiert werden. Ferner bezieht sich die Erfindung auf ein optisch strukturiertes Filter, insbesondere Arbeitsmaske für die photolithographische Herstellung von mikroelektronischen Bauteilen, mit zumindest einem Muster mit durch Ionenimplantation veränderter Transmission für die zu filternde elektromagnetische Strahlung.

Bisher bekannte Verfahren zur Herstellung optisch strukturierter Filter für elektromagnetische Strahlung, wie z. B. einer Arbeitsmaske zur photolithographischen Herstellung von mikroelektronischen Bauteilen, erfordern allesamt eine Vielzahl von Verfahrensschritten unter Einbeziehung sowohl von naßchemischen Entwicklungsprozessen als auch von Ätzprozessen, wie etwa naßchemisches Ätzen, reaktives Plasmaätzen sowie « Ionmilling ».

Bekannt sind Verfahren, bei denen auf einem strahlendurchlässigen Trägermaterial, vornehmlich aus synthetischem Quarzglas, zuerst eine für den gewünschten Wellenlängenbereich optisch undurchlässige Schicht aus Metall bzw. Metalloxid mit einer Dicke von etwa 80-140 nm und darauf eine Schicht aus Photoresist mit einer Dicke von mindestens 300 nm aufgebracht und die letztere einer Wellenstrahlung (Ultraviolett- bzw. Röntgenstrahlung) oder einem Teilchenstrahl (Elektronen, Ionen) entsprechend einem vorgegebenen Muster ausgesetzt wird. Durch diesen Expositionsprozeß wird ein geändertes Verhalten der exponierten Bereiche des Photoresists gegenüber einem nachfolgenden naßchemischen Entwicklungsprozeß herbeigeführt, so daß etwa im Falle eines als Positivresist bezeichneten Photoresists die vorher exponierten Bereiche durch den Entwicklungsprozeß entfernt werden und die darunterliegende optisch undurchlässige Schicht an diesen Stellen für eine darauffolgende naß- oder plasmachemische Ätzbehandlung zugänglich wird. Durch diese wird die optisch undurchlässige Schicht örtlich entfernt, so daß schließlich nach einem dritten chemischen Verfahrensschritt (reaktives Plasmaätzen bzw. naßchemisches Auflösen des Photoresists), in welchem die noch übriggebliebenen, nicht exponierten Bereiche der Photoresistschicht entfernt werden, eine dem ursprünglichen Belichtungsmuster konforme Arbeitsmaske aus optisch undurchlässigem Material auf einer optisch transparenten Trägerschicht entsteht.

Bei einem relativ neuen Verfahren (J. Electrochem. Soc. 129, p. 827-830, 1982 ; B.A. Maclver) wird direkt auf einem strahlendurchlässigen Trägermaterial aus Quarz eine ebenfalls transparente Schicht aus Positiv-Photoresist aufgebracht und letztere wie oben beschrieben einem Expositionsprozeß mit Ultraviolett-Strahlung oder Elektronenstrahlen entsprechend einem vorgegebenen Muster ausgesetzt. In einem naßchemischen Entwicklungsprozeß werden die exponierten Bereiche des Photoresists durchgehend bis auf das transparente Trägermaterial entfernt und die übriggebliebenen, nicht exponierten Bereiche der Photoresistschicht durch Implantation von Silizium-Ionen in einem vor allem im Ultraviolett nahezu völlig strahlungssperrenden Zustand übergeführt, so daß ebenfalls eine dem ursprünglichen Belichtungsmuster konforme Arbeitsmaske aus optisch undurchlässigem Material auf einer optisch transparenten Trägerschicht entsteht.

Sämtliche hier beschriebenen Herstellungsverfahren können als naßchemische bzw. lithographische Verfahren klassifiziert werden, bei welchen eine Schicht aus Photoresist durch unterschiedliche Expositionsprozesse (Ultraviolett- bzw. Röntgenstrahlung, Elektronen- oder Ionenbestrahlung) örtlich in ihrem chemischen Verhalten verändert wird. Allen bekannten Verfahren ist überdies die Notwendigkeit eines oder mehrerer naßchemischer bzw. plasmachemischer Verfahrensschritte gemeinsam.

Abgesehen von der Anzahl der nötigen Verfahrensschritte verursachen diese auch noch andere nachteilige Effekte : Bei naßchemischen Ätzverfahren ist die Unterätzung, d. h. die laterale Ausweitung der Ätzwirkung unterhalb der die Ätzflüssigkeit abschirmenden strukturierten Photoresistschicht relativ groß, so daß die Untergrenze der somit erzielbaren Strukturbreiten bei etwa 600-700 nm liegt. Plasmachemische Ätzverfahren weisen wohl diesen Nachteil fast nicht auf, verursachen jedoch infolge eines nicht vollkommen vermeidbaren Angriffs auf die Oberfläche des transparenten Trägermaterials optische Beugungseffekte beim Einsatz der Maske in photolithographischen Verfahren.

Ein weiterer Nachteil der hier beschriebenen Herstellungsverfahren liegt darin, daß die so erzeugten Arbeitsmasken keine glatte Oberfläche besitzen ; vielmehr weist die Oberfläche der optisch undurchlässichen Schicht eben an jenen Stellen Ausnehmungen von der Tiefe der Schichtdicke auf, die dem ursprünglichen Belichtungsmuster entsprechen. Dadurch erhöht sich gegenüber einer Maske mit glatter Oberfläche die Gefahr der Verschmutzung durch kleine Staubpartikel, die sich in diesen Vertiefungen ansammeln und nur äußerst schwer wieder entfernt werden können. Dies führt zu einer Erhöhung der Fehlerquote bei der Herstellung von Mikroelektronikbauteilen.

Aus den Patent Abstracts of Japan, Bd. 6, Nr. 104 (P-122) (982) ist es bekannt, einen Ionenstrahl einzusetzen, der mit einer Ablenkelektrode über eine Schicht aus Chrom bzw. Chromdioxid geführt wird, um darin Alkali-Ionen an bestimmten Stellen zu implantieren, um diese Stellen später selektiv in einem Ätzprozeß herauslösen zu können. Als Ergebnis erhält man eine Chrommaske, die jedoch einem Ätzschritt mit allen seinen Nachteilen unterworfen wurde. Ferner ist zu bemerken, daß bei dieser Maske die bestrahlten Stellen herausgeätzt und durchsichtig und die unbestrahlten Stellen undurchsichtig sind, was im Gegensatz zu dem weiter unten näher erläuterten Aufbau des erfindungsgemäßen Filters steht.

Aus den Patent Abstracts of Japan, Bd. 6, Nr. 262 (P-164) (1140) ist es bekannt, Arsenionen in eine Silikonschicht zu implantieren, gefolgt von einer Oxidation der Silikonschicht. An den implantierten Stellen erfolgt eine rasche Oxidation und die Ausbildung eines undurchlässigen Musters in einem folgenden Behandlungsschritt. Auch bei dieser zweistufigen Vorgangsweise schließt an die Implantierung somit eine notwendige naßchemische Behandlung mit den dieser innewohnenden Nachteilen an.

Ziel der Erfindung ist es, ein Verfahren der eingangs erwähnten Art vorzuschlagen, das eine einfache Herstellung von optisch strukturierten Filtern für elektromagnetische Strahlung, insbesondere von Arbeitsmasken, vorzugsweise mit Strukturbreiten von weniger als 1 µm, ermöglicht und die Nachteile der vorher erwähnten Verfahren vermeidet. Aufgabe der Erfindung ist es ferner, die bisher notwendige Anzahl der Verfahrensschritte zu reduzieren, insbesondere die bisher notwendigen naßchemischen bzw. plasmachemischen Verfahrensschritte mit ihren inhärenten Nachteilen zu vermeiden, und anderseits optisch strukturierte Filter mit einer weitgehend glatten unstrukturierten Oberfläche herzustellen, um die Verschmutzungsgefahr des Filters hintanzuhalten.

Erfindungsgemäß wird dies bei einem Verfahren der eingangs genannten Art dadurch erreicht, daß die Herstellung der optischen Struktur des eine glatte unstrukturierte Oberfläche aufweisenden Filters durch Ionenimplantation in eine homogen aufgebaute Filterschicht in einem einzigen Verfahrensschritt unter Vermeidung naßchemischer bzw. plasmachemischer Verfahrensschritte erfolgt, nämlich indem die Ionenimplantation in dem (den) Muster(n) mittels wenigstens eines feinfokussierten Ionenstrahles erfolgt, welcher durch elektromagnetische Ablenkvorrichtungen entsprechend dem (den) Muster(n) auf der Filterschicht positioniert bzw. geführt wird oder die Ionenimplantation in dem (den) Muster(n) mit wenigstens einem feinfokussierten Ionenstrahl dadurch erfolgt, daß dieser ortsfest gehalten ist und die Filterschicht unter diesem bzw. diesen feinfokussierten Ionenstrahl(en) entsprechend dem (den) Muster(n) mechanisch positioniert bzw. geführt wird oder die Ionenimplantation in dem (den) Muster(n) mittels eines ungebündelten bzw. eines schwach gebündelten Ionenstrahles derart erfolgt, daß dieser auf eine entsprechende, insbesonders maßstäblich vergrößerte Maske auftrifft, die nur an den den Mustern entsprechenden Stellen für den Ionenstrahl durchlässig ist und die durch die dort austretenden Teilstrahlen mittels einer zwischen der Maske und der Filterschicht befindlichen ionenoptischen Abbildungseinrichtung entsprechend, insbesondere verkleinert, auf die Filterschicht abgebildet wird oder die Ionenimplantation mittels eines ungebündelten Ionenstrahles erfolgt, der durch eine direkt mit der Filterschicht in mechanischem Kontakt befindliche Maske, welche das (die) Muster komplementär enthält, durchtritt, wodurch diese(s) Muster maßstäblich (1 : 1), konform auf die Filterschicht übertragen wird. Ein Filter der eingangs genannten Art ist erfindungsgemäß dadurch gekennzeichnet, daß die homogen unstrukturierte, im wesentlichen glatte Filterschicht, die für die zu filternde elektromagnetische Strahlung Muster mit durch Ionenimplantationen veränderter Transmission aufweist, eine unter Vermeidung von naßchemischen bzw. plasmachemischen Verfahrensschritten hergestellte glatte und unstrukturierte Oberfläche besitzt.

Auf diese Weise ist es möglich, das Herstellungsverfahren derartiger Filter wesentlich zu vereinfachen und insbesondere die bei der Herstellung bekannter Filter nur schwer beherrschbaren naßchemischen Prozesse, z. B. Ätzprozesse, zu vermeiden. Hiedurch ist eine besonders einfache Herstellung von strukturierten Filtern für elektromagnetische Strahlung möglich, wobei für die Herstellung der optischen Struktur des Filters nur ein Verfahrensschritt notwendig ist.

Bei der Ionenimplantation dringen die Ionen zufolge der ihnen erteilten kinetischen Energie in die Filterschicht ein, wo sie dann stationär verbleiben. Durch Wahl von Art und/oder Energie und-/oder Dosis der implantierten Ionen ergibt sich die jeweils angestrebte Durchlässigkeitscharakteristik, d.h. an jenen Stellen, an denen Ionen in die Schicht implantiert werden, entstehen Muster mit veränderter Transmission für die zu filternde elektromagnetische Strahlung einer bestimmten Wellenlänge bzw. in einem bestimmten Wellenlängenbereich. In einer besonderen Ausführungsform ist vorgesehen, daß durch örtlich unterschiedliche Implantation mit unterschiedlichen Ionenarten (z. B. Ionen unterschiedlicher Elemente, Molekülionen, Ionen mit unterschiedlicher elektrischer Ladung) und/oder mit Ionen unterschiedlicher Energie Musterbereiche mit zueinander unterschiedlicher Transmission für elektromagnetische Strahlung von gleicher oder unterschiedlicher Wellenlänge erzeugt werden.

Nach dem erfindungsgemäßen Verfahren ergibt sich zusätzlich der weitere Vorteil, daß infolge der geringen Reichweite gestreuter Ionen in Festkörpern (wenige 10 nm) die Ionen bei der Implantation in der unmittelbaren Nähe ihres Einschußortes lokalisiert bleiben, so daß praktisch keine Strukturverbreiterung in der die Ionen aufnehmenden Filterschicht durch Streuung auftritt, wie dies z. B. bei der Elektronenstrahllithographie durch Bildung von Sekundärelektronen beim Eindringen eines gebündelten Elektronenstrahls in eine Photoresistschicht der Fall ist. Aus diesem Grunde ist es beim erfindungsgemäßen Verfahren möglich, strukturierte Filter, wie z. B. Arbeitsmasken für die optische Lithographie, mit einer derzeit sinnvollen Strichstärke bis hinab zu 200 nm herzustellen. Werden die Muster mit einem gebündelten Metall-Ionenstrahl geschrieben, der durch elektromagnetische Ablenkung positioniert bzw. geführt wird, so kann derzeit in üblichen Anlagen der Strahl einer Feldemissions-Ionenquelle auf einen Durchmesser von 40 nm gebündelt werden und mit einem solchen Strahl können Muster mit einer Strichbreite von etwa 50 nm auf einfache Weise hergestellt werden.

Als Material für die Filterschicht kommen solche Substanzen in Frage, die für die zu filternde Strahlung genügend transparent sind und durch Ionenimplantation ihre Transmission verändern. Zweckmäßig ist es, wenn in Filterschichten aus organischen Polymeren oder Gläsern Sauerstoffionen implantiert werden. Je nach verwendeter Substanz kann es vorteilhaft sein, unterschiedliche Ionen für die Implantation einzusetzen.

Besonders geeignet sind homogen aufgebaute bzw. leicht homogen herstellbare Substanzen, wie organische und anorganische Polymere (z. B. Polymethylmethacrylat, Silikone), organische und anorganische Gläser (z. B. Acrylglas, synthetischer Quarz). Darüber hinaus eignen sich mono- bzw. polykristalline Substanzen, insbesondere Oxide und Nitride (z. B. Quarz, Saphir, Siliziumnitrid). Für Filter im niederenergetischen Röntgenbereich sind Metalle mit niedriger Ordnungszahl als Filterschicht geeignet.

Bei einer besonderen Ausführungsform der Erfindung ist vorgesehen, daß die Filterschicht eines Filters für Kontaktlithographie auf nicht ebenen Oberflächen aus einer Substanz entsprechend geringer Biegesteifigkeit, insbesondere aus organischen bzw. anorganischen Polymeren homogen aufgebaut ist. Damit sind dünne, an nicht ebene Oberflächen sich anpassende Filter bzw. Arbeitsmasken herstellbar, mit denen auf nicht ebenen Oberflächen kontaktlithographische Prozesse realisierbar sind.

Zur Erhöhung der mechanischen Festigkeit von Filtern kann vorgesehen sein, daß die Filterschicht auf eine Trägerschicht mit ausreichender mechanischer Festigkeit und ausreichender Transparenz, zumindest für ausgewählte Bereiche der zu filternden elektromagnetischen Strahlung, aufgebracht ist, z. B. für Wellenlängen unter 400 nm auf synthetischem Quarz. Es ist ferner z. B. möglich, daß synthetisches Quarzglas als Material für die Filterschicht oder für die Trägerschicht verwendet wird.

Eine besonders geeignete Ausführungsform der Filter ist dadurch gekennzeichnet, daß für Filter in einem Wellenlängenbereich unterhalb 400 nm die Dicke der Filterschicht höchstens 400 nm, vorzugsweise 100 bis 200 nm, beträgt und die Filterschicht auf einer Trägerschicht aufgebaut ist. Diese Filter eignen sich für den UV und fernen UV-Bereich.

Zur Erzielung möglichst hoher Kantenschärfe der zu implantierenden Muster ist es zweckmäßig, wenn die Oberfläche der Filterschicht während der Ionenimplantation auf konstantem elektrischen Potential gehalten wird. Ist die Oberfläche der Filterschicht nicht genügend elektrisch leitfähig, kann dies auch dadurch erreicht werden, daß je nach der elektrischen Leitfähigkeit der Filterschicht deren Oberfläche vor der Ionenimplantation durch Aufbringung einer dünnen, elektrisch leitenden Schicht, vorzugsweise einer Goldschicht mit einer Dicke von 3 bis 20 nm, leitend gemacht wird und daß diese elektrisch leitende Schicht während der Ionenimplantation auf konstantem elektrischen Potential gehalten wird und daß vorteilhafterweise diese elektrisch leitende Schicht nach Abschluß der Erzeugung der (des) Muster(s) unterschiedlicher Transmission wieder entfernt wird.

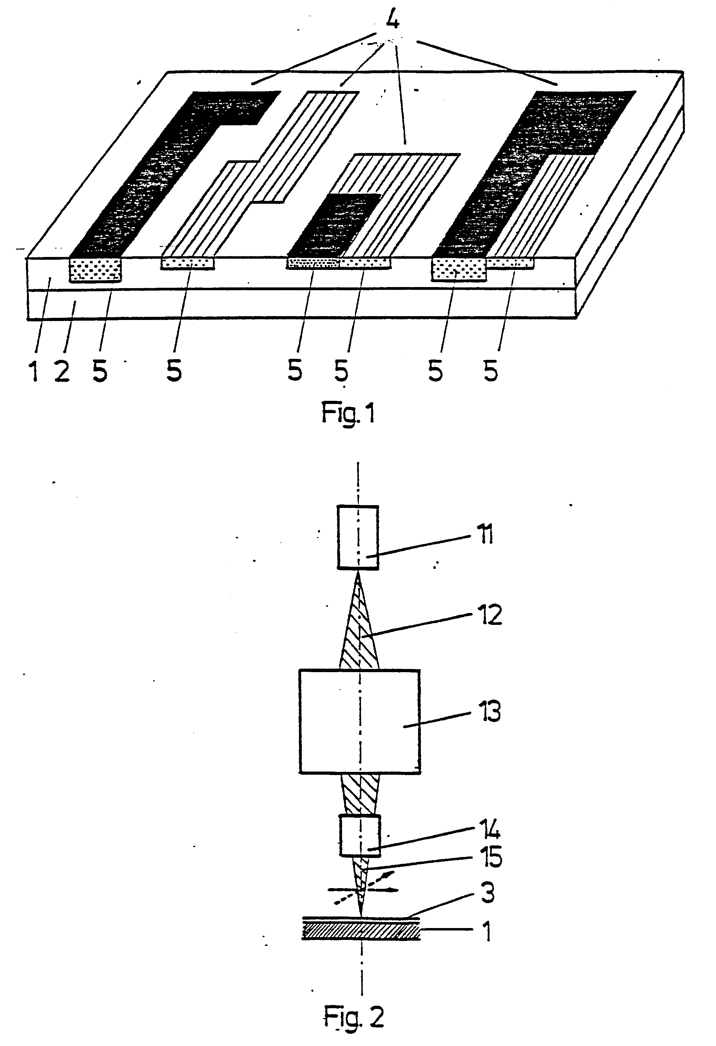

Nachstehend werden das erfindungsgemäße Verfahren und die nach diesem hergestellten Filter an Hand der Fig. 1-4 in nicht einschränkender Weise näher beschrieben.

Fig. 1 zeigt ein Detail eines nach dem erfindungsgemäßen Verfahren hergestellten Filters. Die Filterschicht 1 aus einem organischen Polymer (z. B. Polymethylmethacrylat) ist auf einem Träger 2 aus synthetischem Quarzglas aufgebaut.

Die Fig. 1 zeigt das Filter sowohl in der Aufsicht als auch im Schnitt. Es sind vier voneinander deutlich unterscheidbare Muster 4 mit Bereichen 5 unterschiedlicher Transmission erkennbar. Im linken Teil des Filters sind zwei in ihrer geometrischen Anordnung unterschiedliche Muster 4 dargestellt, die voneinander unterschiedliche Transmission, jedoch im Muster selbst einheitliche Transmission aufweisen. Im Schnitt erkennt man die unterschiedliche Implantationstiefe. Im rechten Teil des Filters erkennt man zwei Muster 4, die jeweils aus zwei Bereichen 5 mit unterschiedlicher Transmission zusammengesetzt sind. Bereiche verschiedener Transmission unterscheiden sich durch die Ionenart, Implantationstiefe und Teilchenkonzentration. Diese Unterschiede werden durch Variation der Implantationsparameter (z. B. Ionenart, Ionenenergie, Ionendosis) erzielt.

Gemäß Fig. 2 kann die Ionenimplantation in an und für sich bekannter Weise dadurch erfolgen, daß ein aus einer Ionenquelle 11 extrahierter Ionenstrahl 12 durch Ionenlinsen 13, bzw. einer Kombination 13 solcher Linsen auf einen Durchmesser fokussiert wird, der kleiner ist als die kleinste gewünschte Strukturbreite jener Bereiche 5, die mit veränderter Transmission ausgebildet werden sollen. Dieser feinfokussierte Ionenstrahl 15 wird durch eine ebenfalls bekannte elektrische oder magnetische Ablenkeinrichtung 14 so gesteuert, daß ein dem zu erzeugenden Filter entsprechendes Muster mit dem Ionenstrahl 15 in die Filterschicht 1 implantiert wird.

Alternativ hiezu kann der Ionenstrahl in seiner Position fixiert bleiben und die Muster 4 bzw. Bereiche 5 dadurch erzeugt werden, daß die Filterschicht 1 unter dem feinfokussierten Ionenstrahl 15 so bewegt wird, daß ebenfalls die Ionen nur in dem dem zu erzeugenden Filter entsprechenden Muster in die Filterschicht 1 implantiert werden. Wird als Ionenquelle 11 z. B. eine Flüssigmetall-Feldemissionsquelle verwendet, so läßt sich ein besonders hoher Ionenstrom in Gebiete mit sehr kleiner Ausdehnung fokussieren. Dadurch können Filter sehr kleiner Strukturbreite in besonders kurzer Zeit hergestellt werden.

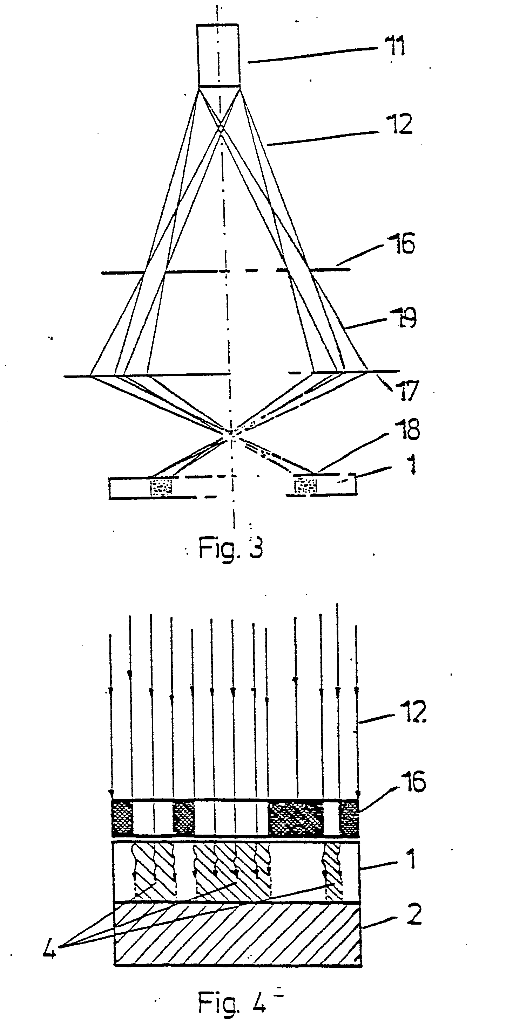

In Fig. 3 wird eine weitere Möglichkeit der Durchführung des erfindungsgemäßen Verfahrens gezeigt, in welchem zum Implantieren des Musters ein ungebündelter bzw. ein nur schwach gebündelter, eine maßstäblich vergrößerte Maske 16 durchdringender, von einer Ionenquelle 11 gelieferter Ionenstrahl 12 verwendet wird. Diese Maske 16 wird als Bild 18 vergrößert oder verkleinert auf die Polymerschicht 1 unter Verwendung der Abbildungseinrichtung 17 projiziert. Bei dieser Durchführungsvariante wird zuerst eine Primärmaske 16, meist aus Metall, hergestellt, die nur an den, den Mustern 4 des Filters entsprechenden Stellen, für den Ionenstrahl 12 durchlässig ist. Diese Primärmaske 16 wird durch einen Ionenstrahl 12 großer Ausdehnung beleuchtet, wobei durch die Ausnehmungen dieser Maske 16 Teilionenstrahlen 19 austreten, die in Form des Maskenmusters angeordnet sind und durch bekannte ionenoptische Abbildungseinrichtungen 17 fokussiert auf die Filterschicht 1 auftreffen. Durch diese ionenoptische Abbildung kann die gewünschte Verkleinerung oder Vergrößerung der Bereiche bzw. Muster erzielt werden. Auf diese Weise lassen sich die gewünschten Muster besonders genau auf der Arbeitsmaske herstellen, wobei auch sehr dünne Strukturbreiten erreichbar sind.

In Fig. 4 wird eine andere Möglichkeit der Durchführung des erfindungsgemäßen Verfahrens gezeigt, die darin besteht, daß mit der Filterschicht 1 eine das einzuschreibende Muster im Maßstab 1 : 1 tragende Maske 16 in Kontakt gebracht wird und anschließend einem ungebündelten Ionenstrahl 12 ausgesetzt wird. Die Filterschicht 1 kann von einem Substrat 2 getragen sein.

Grundsätzlich ist zu bemerken, daß sich erfindungsgemäß hergestellte Arbeitsmasken außer für die Strukturierung von Festkörperoberflächen zur Erzeugung mikroelektronischer Bauteile auch zur Erzeugung von Bauteilen der integrierten Optik, zur Erzeugung von ein und zweidimensionalen Beugungsgittern für elektromagnetische Strahlung und zur Erzeugung von Zonenplatten eignen.

Die Erfindung wird nun an Hand von unterschiedlichen Durchführungsbeispielen gemäß Fig. 1 und 2 näher erläutert :

Als Träger 2 wurde reines synthetisches Quarzglas verwendet, wie es in der Deep-UV-Lithographie benötigt wird, um die Durchlässigkeit für die zur Belichtung erforderliche Wellenlänge zu gewährleisten. Auf dem Träger 2 wurde eine homogene, 300 nm dicke UV-durchlässige, organische Schicht 1 aus Polymethylmethacrylat (PMMA) aufgespinnt und mit einer etwa 4 nm dicken Goldschicht besputtert. In einem Alternativversuch wurde eine selbsttragende Folie aus Polyterephthalsäureester mit einer Dicke von 50 μm als Filterschicht 1 verwendet. Die erfindungsgemäße Filterherstellung erfolgte durch schreibende Ionenimplantation, wobei als Ionenquelle 11 eine Flüssigmetall-Feldionisationsquelle benutzt wurde, aus der ein Strahl 12 von Indiumionen hohen Richtstrahlwertes extrahiert wurde. In Alternativversuchen wurden Zinnionen, ebenfalls aus einer Feldionisationsquelle, aber auch Sauerstoffionen, mit einer Duoplasmatron-Ionenquelle 11 erzeugt, zur Implantation herangezogen, wobei ebenfalls eine ausreichende Transmissionsänderung sowie eine gleichwertige Kantenschärfe wie bei der Implantation von Indium erzielt wurde.

Der Ionenstrahl 12 wurde auf eine Energie von 10 keV beschleunigt und so fokussiert, daß ein Ionenstrom von 10 nA einfach geladener Indium-, Zinn- oder Sauerstoffionen in einen Fleck von 5 μm Durchmesser auf der Polymerschicht 1 gebündelt werden konnte. Durch elektrostatische Ablenkung des Ionenstrahles 15 wurde ein Muster in die Filterschicht 1 geschrieben, wobei die lokale Ionendosis etwa $4 \times 10^{15}$ Ionen/cm$^2$ betrug. Nach der Ionenimplantation wurde die verbleibende Goldschicht 3 chemisch abgelöst. Die Verwendbarkeit dieses ionenimplantierten Musters als Arbeitsmaske für die UV-Belichtung wurde dadurch nachgewiesen, daß die implantierte Polymerschicht 1 in Kontakt mit einem positiv arbeitenden Fotoresist (Shipley AZ 1350 J, 600 nm dick) bespinnten Substrat gebracht wurde. Die Belichtung erfolgte mit einer Ultraviolett-Lichtquelle (Quecksilber-Höchstdruckdampflampe) mit einer Belichtungszeit von 3,5 s. Nach dem Entwickeln des so belichteten Fotoresists (Sprühentwicklung 60 s, bei 800 U/min mit AZ 350 Developer, Verdünnung 5 : 1 mit deionisiertem Wasser) ergab sich in der Fotoresistschicht die durch die Maske vorgegebene Strukturierung hoher Kantenschärfe.

Zur Zeit ist man bestrebt, für die Herstellung von mikroelektronischen Bauteilen, intensitätsstärkere Strahlungsquellen im UV- und im Deep UV-Bereich, z.B. Excimer-Laser, für die optische Belichtung einzusetzen. Wellenlängenbereiche von 170-350 nm finden dabei Verwendung. Die erfindungsgemäß hergestellten Filter eignen sich insbesondere für diese spezielle Belichtungsart, wie entsprechende Untersuchungen mit einem Excimer-Laser ergaben. Deep UV- empfindliche Resists (z.B. Shipley AZ 2 400 und PBS) wurden unter Verwendung ionenimplantierter Masken strukturiert, wobei ein unfokussierter Excimer-Laser bei den Wellenlängen 248 nm (KrF) bzw. 193 nm (ArF) als Strahlungsquelle eingesetzt wurde. Die nach dem erfindungsgemäßen Verfahren hergestellten Filter erwiesen sich dabei hinsichtlich der Lebensdauer als wesentlich verbessert gegenüber den üblichen Chrom-Chromoxid-Arbeitsmasken, weil sich bei oberflächenbeschichteten Filtern (derzeitiger Stand der Technik) die hohe Leistungsdichte eines Excimer-Lasers (5 MW/cm$^2$) auf die Metallschicht relativ rasch zerstörend auswirkt.

Des weiteren ermöglicht das gegenständliche Verfahren die Herstellung sehr dünner, sich an nicht ebene Oberflächen anlegender Filter, wenn in eine sehr dünne selbsttragende, transparente Filterschicht 1, z.B. bis zu 20 μm dick, implantiert wird. Derartige Filter ermöglichen die Herstellung von Strukturen auch auf nicht ebenen Oberflächen nach dem Prinzip der Kontaktlithographie. Dabei besteht die Möglichkeit, ohne großen Aufwand den vollständigen Kontakt zwischen Filter und dem mit Resist beschichteten Substrat herzustellen, was mit den zur Zeit verwendeten Maskenmaterialien nicht möglich ist. Mit solchen Filtern wurde Kontaktlithographie auf zylindrischen Oberflächen mit Krümmungsradien Kleiner als 2 mm durchgeführt.

**Patentansprüche**

1. Verfahren zur Herstellung von optisch strukturierten Filtern mit weitgehend glatten Oberflächen, insbesondere von Arbeitsmasken für die photolithographische Herstellung von mikroelektronischen Bauteilen, mit zumindest einem Muster mit gegenüber der Filterschicht unterschiedlicher Transmission für die zu filternde elektromagnetische Strahlung, wobei in die Filterschicht zur Erzeugung der (des) Muster(s) entsprechend der zu erzeugenden Musterkonfiguration (en) Ionen implantiert werden, dadurch gekennzeichnet, daß die Herstellung der optischen Struktur des eine glatte unstrukturierte Oberfläche aufweisenden Filters durch Ionenimplantation in eine homogen aufgebaute Filterschicht in einem einzigen Verfahrensschritt unter Vermeidung naßchemischer bzw. plasmachemischer Verfahrensschritte (z.B. ohne Vorstrukturierung) erfolgt, nämlich indem die Ionenimplantation in dem (den) Muster(n) (4) mittels wenigstens eines feinfokussierten Ionenstrahles (15) erfolgt, welcher durch elektromagnetische Ablenkvorrichtungen (14) entsprechend dem (den) Muster(n) (4) auf der Filterschicht (1) positioniert bzw. geführt wird oder die Ionenimplantation in dem (den) Muster(n) (4) mit wenigstens einem feinfokussierten Ionenstrahl (15) dadurch erfolgt, daß dieser ortsfest gehalten ist und die Filterschicht (1) unter diesem bzw. diesen feinfokussierten Ionenstrahl(en) (15) entsprechend dem (den) Muster(n) (4) mechanisch positioniert bzw. geführt wird oder die Ionenimplantation in dem (den) Muster(n) (4) mittels eines ungebündelten bzw. eines schwach gebündelten Ionenstrahles (12) derart erfolgt, daß dieser auf eine entsprechende, insbesonders maßstäblich vergrößerte Maske (16) auftrifft, die nur an den den Mustern (4) entsprechenden Stellen für den Ionenstrahl (12) durchlässig ist und die durch die dort austretenden Teilstrahlen (19) mittels einer zwischen der Maske (16) und der Filterschicht (1) befindlichen ionenoptischen Abbildungseinrichtung (17) entsprechend, insbesondere verkleinert, auf die Filterschicht (1) abgebildet wird oder die Ionenimplantation mittels eines ungebündelten Ionenstrahles (12) erfolgt, der durch eine direkt mit der Filterschicht (1) in mechanischem Kontakt befindlichen Maske (16), welche das (die) Muster (4) · komplementär enthält, durchtritt, wodurch diese(s) Muster (4) maßstäblich (1 : 1), konform auf die Filterschicht (1) übertragen wird.

2. Verfahren nach Anspruch 1, dadurch gekennzeichnet, daß durch örtlich unterschiedliche Implantation mit unterschiedlichen Ionenarten (z.B. Ionen unterschiedlicher Elemente, Molekülionen, Ionen mit unterschiedlicher elektrischer Ladung) und/oder mit Ionen unterschiedlicher Energie Musterbereiche mit zueinander unterschiedlicher Transmission für elektromagnetische Strahlung von gleicher oder unterschiedlicher Wellenlänge erzeugt werden.

3. Verfahren nach Anspruch 1 oder 2, dadurch gekennzeichnet, daß die Oberfläche der Filterschicht (1) während der Ionenimplantation auf konstantem elektrischen Potential gehalten wird.

4. Verfahren nach einem der Ansprüche 1 bis 3, dadurch gekennzeichnet, daß je nach der elektrischen Leitfähigkeit der Filterschicht (1) deren Oberfläche vor der Ionenimplantation durch Aufbringung einer dünnen, elektrisch leitenden Schicht (3), vorzugsweise einer Goldschicht mit einer Dicke von 3 bis 20 nm, leitend gemacht wird und daß diese elektrisch leitende Schicht (3) während der Ionenimplantation auf konstantem elektrischen Potential gehalten wird und daß vorteilhafterweise diese elektrisch leitende Schicht (3) nach Abschluß der Erzeugung der (des) Muster (s) (4) unterschiedlicher Transmission wieder entfernt wird.

5. Verfahren nach einem der Ansprüche 1 bis 4, dadurch gekennzeichnet, daß Metallionen mit einer Energie von über 1 KeV implantiert werden.

6. Verfahren nach einem der Ansprüche 1 bis 5, dadurch gekennzeichnet, daß in Filterschichten aus organischen Polymeren oder Gläsern Sauerstoffionen implantiert werden.

7. Optisch strukturierter Filter, insbesondere Arbeitsmaske für die photolithographische Herstellung von mikroelektronischen Bauteilen, mit zumindest einem Muster mit durch Ionenimplantation veränderter Transmission für die zu filternde elektromagnetische Strahlung, hergestellt nach einem Verfahren gemäß einem der Ansprüche 1 bis 6, dadurch gekennzeichnet, daß die homogene unstrukturierte im wesentlichen glatte Filterschicht (1), die für die zu filternde elektromagnetische Strahlung Muster mit durch Ionenimplantation veränderter Transmission aufweist, eine unter Vermeidung von naßchemischen bzw. plasmachemischen Verfahrensschritten hergestellte glatte und unstrukturierte Oberfläche besitzt.

8. Optisch strukturierter Filter nach Anspruch 7, dadurch gekennzeichnet, daß in der Filterschicht (1) Muster mit zueinander unterschiedlicher Transmission für elektromagnetische Strahlung mit gleicher oder unterschiedlicher Wellenlänge durch Implantation von Ionen unterschiedlicher Art (z.B. Ionen unterschiedlicher Elemente,

Molekülionen, Ionen unterschiedlicher elektrischer Ladung) und/oder von Ionen unterschiedliche Energie und/oder mit unterschiedlicher Ionendosis ausgebildet sind.

9. Optisch strukturierter Filter nach Anspruch 7 oder 8, dadurch gekennzeichnet, daß die Filterschicht (1) aus zumindest für ausgewählte Wellenlängenbereiche der zu filternden elektromagnetischen Strahlung transparenten Substanzen, z.B. organischen oder anorganischen Polymeren, organischen oder anorganischen Gläsern, mono- oder polykristallinen Oxiden, Nitriden etc., homogen aufgebaut ist.

10. Optisch strukturierter Filter nach einem der Ansprüche 7 oder 9, dadurch gekennzeichnet, daß die Filterschicht (1) eines Filters für Kontaktlithographie auf nicht ebenen Oberflächen aus einer Substanz entsprechend geringer Biegesteifigkeit, insbesondere aus organischen bzw. anorganischen Polymeren, homogen aufgebaut ist.

11. Optisch strukturierter Filter nach einem der Ansprüche 7 bis 10, dadurch gekennzeichnet, daß die Filterschicht (1) auf eine Trägerschicht (2) mit ausreichender mechanischer Festigkeit und ausreichender Transparenz, zumindest für ausgewählte Bereiche der zu filternden elektromagnetischen Strahlung, aufgebracht ist.

12. Optisch strukturierter Filter nach einem der Ansprüche 7 bis 9 oder 11, dadurch gekennzeichnet, daß synthetisches Quarzglas als Material für die Filterschicht (1) oder für die Trägerschicht (2) verwendet wird.

13. Optisch strukturierter Filter nach einem der Ansprüche 7 oder 12, dadurch gekennzeichnet, daß für Filter in einem Wellenlängenbereich unterhalb 400 nm die Dicke der Filterschicht (1) höchstens 400 nm, vorzugsweise 100 bis 200 nm, beträgt und die Filterschicht (1) auf einer Trägerschicht (2) aufgebaut ist.

## Claims

1. A process for the production of optically structured filters with predominantly smooth or planar surfaces, in particular of primary masks for the photolithographic production of microelectronic elements, comprising at least one pattern with a transmission for the electromagnetic radiation to be filtered, which transmission is different in relation to the transmission of the filter layer, with ions being implanted into the filter layer corresponding to the pattern configuration(s) to be produced, characterized in that the production of the optical structure of the filter having a smooth unstructured surface is effected by ion implantation into a homogeneously composed filter layer in a single process step under avoiding of wet or plasmachemical process steps (for instance without prestructuring), namely by effecting the ion implantation into the pattern(s) (4) by means of at least one finely focused ion beam (15) which is positioned or guided on the filter layer (1) corresponding to the pattern(s) (4) by means of electromagnetic deflection means (14) or that the ion implantation in the pattern(s) (4) is effected by means of at least one finely focused ion beam (15) by keeping said beam stationary and mechanically positioning or guiding the filter layer (1) underneath this or these finely focused ion beam(s) (15) corresponding to the pattern(s) (4) or that the ion implantation in the pattern(s) (4) is effected by means of an unfocused or weakly focused ion beam (12) in such a manner that said beam (12) impinges on a corresponding, in particular larger scaled mask (16) which is permeable for the ion beam (12) only in those spots corresponding to the pattern(s) (4) and which is projected on the filter layer (1) correspondingly, in particular demagnified, by means of the partial beams (19) exiting there, by an optical imagining system (17) provided between the mask (16) and the filter layer (1), or that the ion implantation is effected by means of an unfocused ion beam (12) which penetrates a mask (16) which is in direct mechanical contact with the filter layer (1) and contains the pattern(s) (4) complementarily, whereby this pattern (these patterns) (4) is (are) projected into the filter layer in a scale 1 : 1.

2. The process according to claim 1, wherein by locally different implantation with different types of ions (such as the ions of different elements, molecular ions, ions with different electric charge) and/or ions with different energy, pattern zones with different transmission for electromagnetic radiation of different or identical wave length are produced.

3. The process according to claim 1 or 2, wherein the surface of the filter layer (1) is kept at constant electric potential during ion implantation.

4. The process according to any one of the claims 1 to 3, wherein depending on the electric conductivity of the filter layer (1), its surface is made conductive prior to ion implantation by the application of a thin, electrically conductive layer (3), preferably a gold layer with a thickness of 3 to 20 nm, and this electrically conductive layer (3) is kept at a constant electric potential during ion implantation and conveniently, this electrically conductive layer (3) is removed at completion of the production of the pattern(s) (4) of different transmission.

5. The process according to any one of the claims 1 to 4, wherein metal ions with an energy of more than 1 keV are implanted.

6. The process according to any one of the claims 1 to 5, wherein oxygen ions are implanted in filter layers of organic polymers or glasses.

7. Optically structured filter, in particular primary mask for the photolithographic production of microelectronic elements, with at least one pattern with transmission for the electromagnetic radiation to be filtered changed by ion implantation, produced in particular according to any one of the claims 1 to 6, wherein the homogeneous, unstructured, essentially smooth filter surface (1) which has patterns of transmission for the electromagnetic radiation to be filtered changed by ion implantation has a smooth and unstructured surface produced under avoiding of wet chemical or plasmachemical process steps.

8. Optically structured filter according to claim 7, wherein patterns of mutually different transmission of electromagnetic radiation of identical or different wave lengths are provided in the filter layer (1) by implantation of ions of different types (such as ions of different elements, molecular ions, ion of different electric charge) and/or ions of different energy and/or with different ion dose.

9. Optically structured filter according to claim 7 or 8, wherein the filter layer (1) is homogeneously structured of substances transparent at least for selected wave length ranges of the electromagnetic radiation to be filtered, such a organic or inorganic polymers, organic or inorganic glasses, mono-or polycrystalline oxides, nitrides or the like.

10. Optically structured filter according to claim 7 or 9, wherein the filter layer (1) of a filter for contact lithography on non-planar surfaces is homogeneously structured of a substance of correspondingly low rigidity, in particular of organic or inorganic polymers.

11. Optically structured filter according to any one of the claims 7 to 10, wherein the filter layer (1) is applied to a substrate (2) of sufficient mechanical strength and adequate transparency, at least for selected ranges of the electromagnetic radiation to be filtered.

12. Optically structured filter according to any one of the claims 7 to 9 or 11, wherein synthetic quartz glass is used for the material of the filter layer (1) or for the substrate (2).

13. Optically structured filter according to claim 7 or 12, wherein for filters in a wave length range of less than 400 nm, the thickness of the filter layer (1) is at the most 400 nm, preferably 100 to 200 nm, and the filter layer is applied to a substrate (2).

## Revendications

1. Procédé de fabrication de filtres optiques structurés à surface éminemment lisse, particulièrement de masques pour la fabrication photolithographique de composants microélectroniques, avec au moins une figure présentant à l'égard du rayonnement électromagnétique à filtrer une transmission différente de celle de la couche filtrante, des ions étant implantés dans la couche filtrante pour obtenir cette (ces) figure(s) conformément à la (aux) configuration(s) à réaliser, caractérisé en ce que la structure optique du filtre présentant une surface lisse non structurée est obtenue par implantation d'ions dans une couche filtrante de constitution homogène, en une seule opération, sans faire appel aux procédés chimiques par voie humide ou plasma-chimiques (p. ex. sans préstructuration), l'implantation d'ions dans la (les) figure(s) (4) étant effectuée moyennant au moins un faisceau ionique (15) focalisé en un spot de très faibles dimensions, positionné ou guidé sur la couche filtrante (1) conformément à la (les) figure(s) (4) par des dispositifs de déviation électromagnétiques (14), ou bien l'implantation d'ions dans la (les) figure(s) effectuée moyennant au moins un faisceau ionique (15) focalisé en un spot de très faibles dimensions étant réalisée avec le(s) faisceau(x) ionique(s) maintenu(s) fixe(s) tandis que la couche filtrante (1) est positionnée ou guidée mécaniquement sous ce ou ces faisceau(x) ionique(s) (15) focalisé(s) en spot, conformément à la (aux) figure(s) (4), ou bien l'implantation d'ions dans la (les) figure(s) (4) étant obtenue moyennant un faisceau ionique (12) divergent, parallèle ou faiblement convergent, celui-ci étant dirigé sur un masque adéquat (16), en particulier un masque agrandi selon une échelle donnée, dont seules les régions correspondant à la (aux) figure(s) sont perméables au faisceau ionique (12), et étant reproduit sur la couche filtrante (1) sous un rapport donné, en particulier par réduction, par les faisceaux partiels (19) émergeant de ces figures, au moyen d'un dispositif de reproduction opticoionique (17) interposé entre le masque (16) et la couche filtrante (1), ou bien l'implantation d'ions étant effectuée au moyen d'un faisceau ionique (12) divergent ou parallèle traversant un masque (16) en contact mécanique direct avec la couche filtrante (1), ledit masque contenant complémentairement la (les) figure(s) (4), cette (ces) figure(s) (4) étant ainsi reproduite(s) à l'échelle (1 : 1), de façon conforme, sur la couche filtrante (1).

2. Procédé selon la revendication 1 caractérisé en ce que l'on obtient, par implantation de différentes variétés d'ions (p. ex. ions de différents éléments, ions de complexes moléculaires, ions de charges électriques différentes) et/ou d'ions d'énergie différente, en différentes régions, des portions de figures présentant l'une par rapport à l'autre une transmission différente à l'égard d'un rayonnement électromagnétique de même longueur d'onde ou de longueur d'onde différente.

3. Procédé selon la revendication 1 ou 2 caractérisé en ce que la surface de la couche filtrante (1) est maintenue à un potentiel électrique constant pendant la durée de l'implantation ionique.

4. Procédé selon une des revendications 1 à 3 caractérisé en ce que suivant la conductivité de la couche filtrante (1), la surface de celle-ci est rendue conductrice avant l'implantation ionique par application d'une mince couche électroconductrice (3), de préférence une couche d'or d'une épaisseur de 3 à 20 nm, cette couche électroconductrice (3) étant maintenue à un potentiel électrique constant pendant l'implantation ionique et cette couche électroconductrice (3) étant avantageusement enlevée après obtention de la (des) figure(s) (4) présentant une transmission différente.

5. Procédé selon une des revendications 1 à 4 caractérisé en ce que des ions métalliques sont implantés avec une énergie de plus de 1 keV.

6. Procédé selon une des revendications 1 à 5 caractérisé en ce que des ions d'oxygène sont implantés dans des couches filtrantes en verres ou polymères organiques.

7. Filtre optique structuré, en particulier masque pour la fabrication photolithographique de composants microélectroniques avec au moins une figure présentant à l'égard du rayonnement électromagnétique à filtrer une transmission modifiée par implantation d'ions, fabriqué à l'aide d'un procédé selon une des revendications 1 à 6, caractérisé en ce que la couche filtrante (1) homogène, non structurée et essentiellement lisse, présentant pour le rayonnement électromagnétique à filtrer des figures dont la transmission a été modifiée par implantation d'ions, a une surface lisse et non structurée obtenue sans faire appel à un procédé chimique par voie humide ou plasma-chimique.

8. Filtre optique structuré selon la revendication 7 caractérisé en ce que des figures ne présentant pas la même transmission à l'égard de radiations électromagnétiques de même longueur d'onde ou de différentes longueurs d'onde ont été obtenues dans la couche filtrante (1) par implantation de différentes variétés d'ions (p. ex. ions de différents élements, ions de complexes moléculaires, ions de charge différente) et/ou d'ions d'énergie différente et/ou de différentes doses d'ions.

9. Filtre optique structuré selon la revendication 7 ou 8 caractérisé en ce que la couche filtrante (1) est homogènement constituée de substances transparentes au rayonnement électromagnétique à filtrer au moins pour des gammes d'ondes sélectionnées, p. ex. polymères organiques ou anorganiques, verres organiques ou anorganiques, oxydes mono ou polycristallins, nitrures, etc.

10. Filtre optique structuré selon une des revendications 7 ou 9 caractérisé en ce que la couche filtrante (1) d'un filtre pour lithographie par contact sur des surfaces non planes est homogènement constituée d'une substance dont la rigidité flexionnelle est faible en conséquence, en particulier de polymères organiques ou anorganiques.

11. Filtre optique structuré selon une des revendications 7 à 10 caractérisé en ce que la couche filtrante (1) est appliquée sur une couche support (2) de résistance mécanique suffisante et de transparence suffisante, tout au moins pour des gammes d'ondes déterminées du rayonnement électromagnétique à filtrer.

12. Filtre optique structuré selon une des revendications 7 à 9 ou 11, caractérisé en ce que le matériau utilisé pour la couche filtrante (1) ou pour la couche support (2) est du verre quartzeux synthétique.

13. Filtre optique structuré selon une des revendications 7 ou 12, caractérisé en ce que pour les filtres utilisés dans une gamme d'ondes inférieure à 400 nm, l'épaisseur de la couche filtrante (1) ne dépasse pas 400 nm, étant avantageusement comprise entre 100 et 200 nm, et que la couche filtrante (1) est appliquée sur une couche support (2).

0 120 834

Fig. 1

Fig. 2

Fig. 3

Fig. 4